# EUROPÄISCHE PATENTSCHRIFT

(11) **EP 0 951 131 B1**
(45) Veröffentlichungstag und Bekanntmachung des Hinweises auf die Patenterteilung: **13.09.2006**
(21) Anmeldenummer: 99106967.5
(22) Anmeldetag: 09.04.1999
(51) Int. Cl.: H02K 11/04, H02K 9/19, H02K 5/20, H02K 5/22

(54) **Elektrische Antriebseinheit aus Elektromotor und Elektronikmodul**
Electric drive unit consisting of an electric motor and of an electronic unit
Unité d'entraînement électrique comprenant un moteur électrique et un module électronique

(30) Priorität: 18.04.1998 DE 19817333
(43) Veröffentlichungstag der Anmeldung: 20.10.1999
(73) Patentinhaber: Conti Temic microelectronic GmbH, 90411 Nürnberg (DE)
(72) Erfinder: Bitsche, Otmar, 70329 Stuttgart (DE); Bäumel, Hermann, 92318 Neumarkt (DE); Kilian, Hermann, 91456 Diespeck (DE); Schuch, Bernhard, 91616 Neusitz (DE)

(56) Entgegenhaltungen:
- EP-A- 0 661 793
- DE-U- 8 914 756
- US-A- 4 975 825
- US-A- 5 585 681

## Beschreibung

Elektrische Antriebseinheiten werden in vielfältigen Anwendungsgebieten eingesetzt; beispielsweise wird im Kfz-Bereich verstärkt der Gebrauch von emissionsarmen Kraftfahrzeugen propagiert, die zumindest einen Teil der Antriebsenergie und/oder der Energie für Hilfsantriebe auf elektrischem Wege beziehen. Elektrische Antriebseinheiten bestehen aus einem Elektromotor zur Erzeugung und Bereitstellung von elektrischer Antriebsleistung und aus einem Elektronikmodul zur Ansteuerung und überwachung des Elektromotors, beispielsweise zur Drehzahl- und Leistungsregelung des Elektromotors.
Der Elektromotor muß aufgrund seiner hohen Leistungsdichte gekühlt werden und ist daher mit einem Kühlkreislauf ausgestattet (meistens wird hierfür eine Wasserkühlung mit Wasser als Kühlmittel des Kühlkreislaufs verwendet); bei einem doppelwandigen Elektromotorgehäuse ist hierzu ein für den Transport des Kühlwassers vorgesehener Wassermantel zwischen der Außenwand und der Innenwand des Elektromotorgehäuses angeordnet. Beabstandet zum Elektromotor ist als eigenständige Einheit das mehrere Funktionseinheiten (insbesondere eine Leistungseinheit und eine Ansteuereinheit) umfassende Elektronikmodul angeordnet, von denen in der Regel mindestens eine Funktionseinheit eine hohe Verlustleistung aufweist und dementsprechend gekühlt werden muß - zum Abführen dieser Verlustleistung (insbesondere zum Abführen der Verlustleistung der Leistungseinheit) weist das Elektronikmodul einen eigenen Kühlkreislauf auf, der in Reihe zum Kühlkreislauf des Elektromotors geschaltet und mit diesem über Verbindungsschläuche verbunden ist. Zwischen dem Elektronikmodul und dem Elektromotor sind zur Weiterleitung von Sensorsignalen und Steuersignalen sowie zur Spannungsversorgung externe Signalleitungen und Versorgungsleitungen vorgesehen; diese als Kabel ausgebildeten Verbindungsleitungen sind mittels Verbindungssteckern an den hierfür vorgesehenen Steckeranschlüssen von Elektronikmodulgehäuse und Elektromotorgehäuse angeschlossen.

Dieser Aufbau der elektrischen Antriebseinheit mit einer Trennung von Elektromotor und Elektronikmodul, insbesondere mit getrennten Kühlkreisläufen von Elektromotor und Elektronikmodul, bedingt folgende Nachteile:
- die notwendige Verbindung zwischen dem Elektromotor und dem Elektronikmodul zur Realisierung der elektrischen Antriebseinheit ist aufwendig und verursacht Probleme hinsichtlich Zuverlässigkeit, Alterung etc., bsp. Dichtungsprobleme bei den Verbindungsschläuchen zwischen Elektromotor und Elektronikmodul,
- der Flächenbedarf und daher auch das Einbauvolumen der elektrischen Antriebseinheit ist gross,
- die Herstellung der elektrischen Antriebseinheit ist mit relativ hohen Kosten verbunden.
Eine gattungsgemäße Antriebseinheit ist aus der US 5,585,681 A bekannt. Die Druckschrift beschreibt eine Antriebseinheit, bestehend aus einem Elektromotor mit flüssigkeitdurchströmtem Gehäuse und einem Steuergehäuse. Der Boden des Steuergehäuses ist auf das Gehäuse des Elektromotors aufgesetzt und ebenfalls flüssigkeitsgekühlt, wobei der Boden des Steuergehäuses mit dem Motorgehäuse in Serie flüssigkeitsverbunden ist. Auf den Steuergehäuseboden ist ein Chassis angeschraubt und trägt die gesamte Elektronik. Diese Antriebseinheit ist sowohl hinsichtlich des einnehmenden Bauraums als auch hinsichtlich der Kühlleistung nicht optimiert.

Der Erfindung liegt die Aufgabe zugrunde, eine elektrische Antriebseinheit aus Elektromotor und Elektronikmodul anzugeben, die demgegenüber vorteilhafte Eigenschaften aufweist, insbesondere einen einfachen Aufbau und geringe Kosten, eine hohe Zuverlässigkeit und eine vereinfachte Fertigung.

Diese Aufgabe wird bei einer gattungsgemäßen Antriebseinheit erfindungsgemäß durch die Merkmale im Kennzeichen des Patentanspruchs 1 gelöst.

Vorteilhafte Ausgestaltungen der elektrischen Antriebseinheit sind Bestandteil der weiteren Patentansprüche.

Elektromotor und Elektronikmodul bilden eine integrierte elektrische Antriebseinheit, insbesondere wird die Kühlfunktion für Elektromotor und Elektronikmodul gemeinsam realisiert (der Kühlkreislauf wird gemeinsam genutzt). Im Elektronikmodulgehäuse ist hierzu eine Aussparung zur Aufnahme eines Kühlereinlegeteils und in der Außenwand des Elektromotorgehäuses eine hierzu korrespondierende Aussparung vorgesehen; vor dem Zusammenfügen von Elektromotor und Elektronikmodul wird das Kühlereinlegeteil in die Aussparung im Elektronikmodulgehäuse eingelegt, beim Zusammenfügen von Elektromotor und Elektronikmodul liegt das Kühlereinlegeteil (insbesondere bündig) an der Innenwand des Elektromotorgehäuses an und wird somit vollständig in den vom Kühlmittel durchströmten Kühlkreislauf (bsp. in den Wassermantel) des Elektromotors integriert - hierdurch werden Elektromotor und Elektronikmodul (insbesondere die Leistungseinheit des Elektronikmoduls) gleichzeitig gekühlt. Demzufolge sind zur Realisierung der Kühlfunktion der elektrischen Antriebseinheit keine Verbindungsschläuche zwischen dem Elektromotor und dem Elektronikmodul erforderlich, so daß auch die hiermit verbundenen Probleme (Abdichtung der Verbindungsschläuche etc.) entfallen. Da die stärkere Erwärmung der Innenwand gegenüber der Außenwand des Elektromotorgehäuses die Kühlung des Elektronikmoduls und damit auch dessen Funktionsfähigkeit beeinträchtigen kann, ist das Kühlereinlegeteil zur Innenwand des Elektromotorgehäuses hin durch eine auf die Unterseite des Kühlereinlegeteils aufgebrachte thermische Isolationsschicht thermisch isoliert. Diese thermische Isolationsschicht wird bsp. mittels einer auf die Unterseite des Kühlereinlegeteils aufgebrachte, hochtemperaturbeständige Kunststoffolie realisiert, bsp. mittels einer einseitig klebenden Polyimidfolie oder Teflonfolie - bsp. wird hierdurch eine Temperaturbeständigkeit bis 180°C erreicht.
Die Form des Kühlereinlegeteils ist an die Form des Elektromotors und Elektronikmoduls bzw. an die Gehäuseform des Elektromotorgehäuses und Elektronikmodulgehäuses angepaßt; die Größe des Kühlereinlegeteils richtet sich nach der abzuführenden Verlustleistung, d.h. die erforderliche Kühlfunktion muß durch das Kühlereinlegeteil gewährleistet werden. Die an der Innenwand des Elektromotorgehäuses anliegende Unterseite des Kühlereinlegeteils kann zur Vergrößerung der Oberfläche und zur Vorgabe von "Strömungskanälen" für das Kühlmittel mit Geometrieelementen versehen werden, bsp. mit Rauten, Pyramidenstümpfen oder Linsen. Das Kühlereinlegeteil besteht vorzugsweise aus einem Material mit hoher Wärmeleitfähigkeit, bsp. aus Kupfer, Aluminium-Druckguß, AlSiC oder AlN.
Die mechanische Verbindung zwischen Elektromotor und Elektronikmodul erfolgt mittels geeigneter Befestigungselemente, bsp. über mittels Schrauben befestigten Bügeln. Die elektrische Verbindung zwischen Elektromotor und Elektronikmodul erfolgt mittels interner Verbindungsleitungen innerhalb des Gesamtgehäuses der elektrischen Antriebseinheit über Aussparungen im Elektromotorgehäuse und Elektronikmodulgehäuse (bsp. über im Bereich des Lagerschilds des Elektromotors vorgesehene Aussparungen), so daß hierzu keine externen Steckeranschlüsse und keine externen Verbindungsleitungen erforderlich sind.

Im Elektronikmodul sind mehrere, auf jeweils einem Schaltungsträger angeordnete Funktionseinheiten in einem mehrere Schaltungsebenen umfassenden kompakten Aufbau integriert: bsp. in einer ersten Schaltungsebene eine Leistungseinheit mit Leistungshalbleiterbauelementen zur Erzeugung der getakteten Phasenströme für den Elektromotor, in einer zweiten Schaltungsebene oberhalb der Leistungseinheit eine auf einer Hochstrom-Leiterplatte angeordnete Verbindungseinheit mit Leiterbahnen und Anschlußflächen zur Phasenverschienung, DC-Versorgung und Kontaktierung und in einer weiteren Schaltungsebene oberhalb der Verbindungseinheit eine Ansteuereinheit zur Ansteuerung und Überwachung der Leistungshalbleiterbauelemente der Leistungseinheit. Zwischen den Schaltungsträgern der verschiedenen Schaltungsebenen, d.h. zwischen dem Schaltungsträger der Leistungseinheit und dem Schaltungsträger der Verbindungseinheit (der Hochstrom-Leiterplatte) sowie zwischen dem Schaltungsträger der Ansteuereinheit und dem Schaltungsträger der Verbindungseinheit (der Hochstrom-Leiterplatte) sind Verbindungselemente (bsp. aus Kupfer oder KupferLegierungen) mit Ausgleichssicken zur mechanischen Entkopplung der verschiedenen Schaltungsebenen vorgesehen.

Die Integration von Elektromotor und Elektronikmodul in einer kompakten elektrischen Antriebseinheit und die gleichzeitige Nutzung der Kühlfunktion ist vorteilhafterweise verbunden mit einem geringen Einbauvolumen der elektrischen Antriebseinheit, mit guten elektrischen Eigenschaften durch Wegfall der externen Verbindungsleitungen bzw. durch Realisierung sehr kurzer interner Verbindungsleitungen, mit einer hohen Zuverlässigkeit und Lebensdauer sowie mit einer geringen Kosten bei der Realisierung der elektrischen Antriebseinheit.

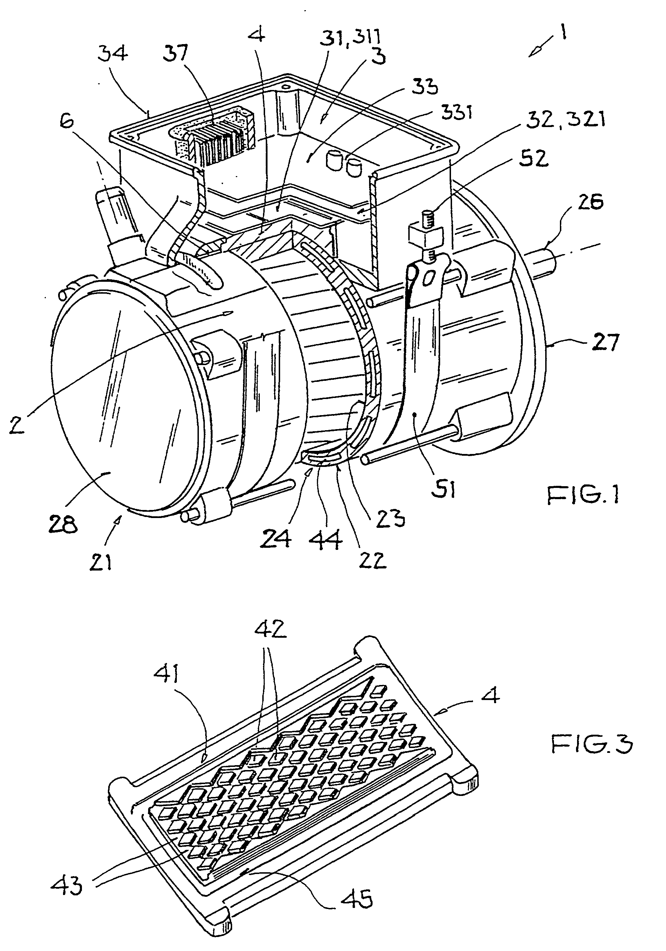

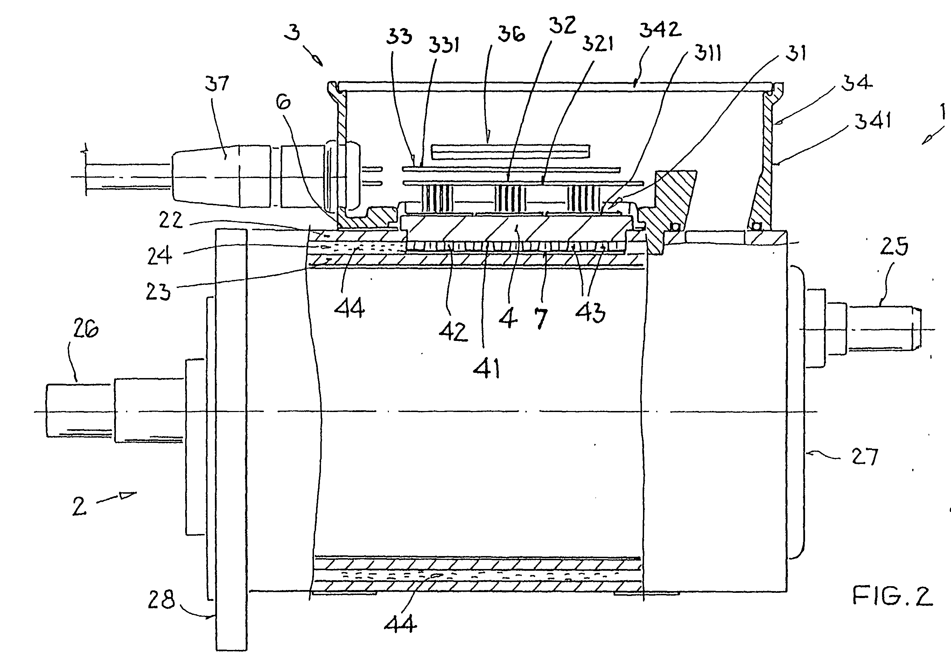

Im Zusammenhang mit der Zeichnung (Figuren 1 bis 3) soll die elektrische Antriebseinheit anhand eines Ausführungsbeispiels erläutert werden. In der Zeichnung ist hierbei folgendes dargestellt:
- Figur 1: eine dreidimensionale Ansicht der elektrischen Antriebseinheit,
- Figur 2: eine Schnittdarstellung der elektrischen Antriebseinheit,
- Figur 3: eine Detailansicht des Kühlereinlegeteils.

Die elektrische Antriebseinheit 1 aus Elektromotor 2 und Elektronikmodul 3 soll bsp. zur Bereitstellung elektrischer Leistung für die Hilfsantriebe eines mittels einer Brennstoffzelle angetriebenen Kraftfahrzeugs herangezogen werden.
Der Elektromotor 2 der elektrischen Antriebseinheit 1 ist bsp. ein wassergekühlter Reluktanz.Motor ("SR-Motor" "shift reluctance") mit einer Nennleistung von bsp. 8 kW; zwischen der Innenwand 23 und der Außenwand 22 des den Stator des Elektromotors 2 umschließenden Elektromotormotorgehäuses 21 ist der umlaufende außenliegende Kühlkreislauf (Wassermantel 24) zur Aufnahme des Kühlmittels (Kühlwasser 44) angeordnet. Der Elektromotor 2 beitzt zwei axial an gegenüberliegenden Stirnseiten 27, 28 angebrachte Lagerschilde 25, 26: der erste, an der Stirnseite 28 befindliche Lagerschild 26 des Elektromotors 2 ist mit der Arbeitswelle (Antriebswelle) verbunden, der zweite, an der Stirnseite 27 befindliche Lagerschild 25 des Elektromotors 2 ist als Einlauf und Ablauf des Kühlwassers 44 mit dem Wassermantel 24 verbunden.
Das Elektronikmodul 3 der elektrischen Antriebseinheit 1 besteht aus
- einer in einer ersten Schaltungsebene angeordneten Leistungseinheit 31, deren Bauelemente auf einem für hohe Ströme und für eine ausreichende Abführung der Verlustleistung geeigneten Trägerkörper 311 aufgebracht sind; bsp. sind die Halbleiterbauelemente der Leistungseinheit 31 auf DCB-Substrate 311 ("Direct Copper Bonding": Keramikträger zwischen zwei Kupferschichten) aufgebracht, wobei die erforderliche Stromtragfähigkeit der Leistungseinheit 31 bsp. durch Parallelschaltung dreier DCB-Substrate 311 erreicht wird. Ein DCB-Substrat 311 besitzt bsp. die Abmessungen 35 mm x 49 mm, wobei die beiden Kupferschichten bsp. eine Dikke von jeweils 300 µm und der dazwischen angeordnete, bsp. aus AIN bestehende Keramikträger bsp. eine Dicke von 0.635 mm besitzt. Die DCB-Substrate 311 sind unmittelbar auf das aus einem gut wärmeleitfähigen Material bestehende und für die Leistungseinheit 31 als Kühlkörper fungierende Kühlereinlegeteil 4 aufgebracht und mit diesem bsp. durch Löten verbunden.
- einer Verbindungseinheit 32, die in einer zweiten Schaltungsebene oberhalb der Leistungseinheit 31 auf einer Hochstrom-Leiterplatte 321 angeordnet ist; die Verbindungseinheit 32 dient zur Gleichspannungsverteilung (DC-Verschienung), zur Phasenverschienung der Motorphasen des Elektromotors 2, zur Realisierung von Steuerleitungen für die Ansteuereinheit 33, und zur Kontaktierung von Bauelementen der Leistungseinheit 31 und Ansteuereinheit 33 sowie von weiteren Bauelementen des Elektronikmoduls 3. Bsp. besteht die Hochstrom-Leiterplatte 321 aus einem FR4-Material und besitzt eine Grundfläche von 100 mm x 100 mm; bei einem vierlagigen Aufbau (vier Einzellagen) weist die Hochstrom-Leiterplatte 321 bsp. eine Gesamtdicke von 2.5 mm auf. Beispielsweise besitzen bei einer in vier Leitbahnebenen realisierten Leitbahnstruktur (vierlagiger Aufbau der Hochstrom-Leiterplatte 321) und bei einer Gesamtdicke der Leitbahnstruktur (der bsp. aus Kupfer bestehenden Leiterbahnen) von ca. 500 µm die Leiterbahnen der beiden sich im Innern der Hochstrom-Leiterplatte 321 befindlichen Leitbahnebenen (die beiden Innenlagen) jeweils eine Schichtdicke von 110 µm und die Leiterbahnen der beiden sich auf der Außenseite der Hochstrom-Leiterplatte 321 befindlichen Leitbahnebenen (die beiden Außenlagen) jeweils eine Schichtdicke von 140 µm.
- einer Ansteuereinheit 33, die in einer dritten Schaltungsebene oberhalb der Hochstrom-Leiterplatte 321 der Verbindungseinheit 32 in minimalem senkrechten Abstand auf einem Trägerkörper 331 angeordnet ist; die Bauelemente der Ansteuereinheit 33 werden beispielsweise beidseitig auf eine Leiterplatte als Trägerkörper 331 aufgebracht. Bsp. ist diese Leiterplatte 331 aus einem FR4-Material ausgebildet und besitzt eine Grundfläche von 100 mm x 100 mm; bei einer in sechs Leitbahnebenen realisierten Leitbahnstruktur (sechslagiger Aufbau des Trägerkörpers 331) weist die Leiterplatte 331 bsp. eine Gesamtdicke von 2 mm auf.
- einem Elektronikmodulgehäuse 34 mit integrierten Kfz-tauglichen Stekkeranschlüssen 36, 37 zum Anschluß von Verbindungsleitungen; bsp. sind zwei Steckeranschlüsse 36, 37 vorgesehen, ein Steckeranschluß 37 als Gleichspannungseingang von der Brennstoffzelle und ein Steckeranschluß 36 zum Anschluß von Signalleitungen bzw. Steuerleitungen zum Kraftfahrzeug hin (bsp. zum Anschluß an einen Datenbus des Kraftfahrzeugs, bsp. an einen CAN-Bus). Das Elektronikmodulgehäuse 34 ist bsp. zweigeteilt und besteht bsp. aus einem Gehäuseseitenteil 341 und aus einem auf das Gehäuseseitenteil 341 aufgesetzten und mit diesem verklebten Gehäusedeckel 342.
- weiteren Bauelementen, insbesondere Entstörelementen wie bsp. Kondensatoren und Ferritringen, zur Vermeidung von externen Störeinflüssen wie EMV-Einstrahlungen, Stromwelligkeiten (Ripples) oder Überspannungen etc.; diese weiteren Bauelemente sind mit der Hochstrom-Leiterplatte 321 der Verbindungseinheit 32 bzw. mit dem Elektronikmodulgehäuse 34 elektrisch und/oder mechanisch verbunden.

Das Kühlereinlegeteil 4 besteht bsp. aus mit Füllstoffen versehenem Al-Druckguß und besitzt bsp. die Abmessungen 121 mm x 76 mm sowie eine Dicke von 10 mm. Wie in der Figur 3 dargestellt, sind an der Unterseite 41 des Kühlereinlegeteils 4 als Geometrieelemente 42 zur Vergrößerung der kühlenden Oberfläche bzw. zur Vorgabe von Strömungskanälen 43 für das Kühlwasser 44 bsp. Rauten angebracht; das Kühlwasser 44 muß demzufolge in den Strömungskanälen 43 zwischen den Rauten 42 hindurchströmen, so daß aufgrund von erzwungener Konvektion eine gute Kühlwirkung durch das Kühlereinlegeteil 4 gewährleistet wird.
Vor dem Zusammenfügen von Elektromotor 2 und Elektronikmodul 3 wird das Kühlereinlegeteil 4 mit der unmittelbar hierauf aufgebrachten Leistungseinheit 31 in eine an die Größe des Kühlereinlegeteils 4 angepaßte Aussparung im Elektronikmodulgehäuse 34 eingelegt. Beim Zusammenfügen von Elektromotor 2 und Elektronikmodul 3 wird das Kühlereinlegeteil 4 in eine Aussparung in der Außenwand 22 des Elektromotorgehäuses 21 formschlüssig eingebracht und mit den Geometrieelementen 42 (Rauten) bündig auf die Innenwand 23 des Elektromotorgehäuses 21 aufgesetzt; hiermit wird das Kühlereinlegeteil 4 in den Wassermantel 24 des Elektromotors 1 integriert und die Kühlung des Elektronikmoduls 3 direkt an die Kühlung des Elektromotors 2 gekoppelt. Die Abdichtung des Kühlereinlegeteils 4 zum Elektromotor 2 hin (d.h. die Abgrenzung des Wassermantels 24 als Kühlkreislauf) kann bsp. mittels einer Formdichtung 6 erfolgen, bsp. mittels eines bsp. aus einem synthetischen Gummi (bsp. aus NBR) bestehenden Formelements 6; hierzu wird die Formdichtung 6 in eine an der Umrandung des Kühlereinlegeteils 4 umlaufende Nut 45 (siehe Figur 3) eingebracht. Die thermische Entkopplung von Kühlereinlegeteil 4 und Innenwand 23 des Elektromotorgehäuses 21 wird mittels einer auf die Unterseite 41 des Kühlereinlegeteils 4 (auf die Geometrieelemente 42 des Kühlereinlegeteils 4) aufgebrachten thermischen Isolationsschicht 7 realisiert, bsp. durch eine (bsp. aufgeklebte) thermische Isolationsfolie 7; die thermische Isolationsfolie 7 ist bsp. als Kunststoffolie mit relativ schlechter Wärmeleitung ausgebildet, bsp. als einseitig klebende Kunststoffolie aus Polyester oder Kapton.

Die elektrische Verbindung zwischen Elektromotor 2 und Elektronikmodul 3 beim Zusammenfügen von Elektromotor 2 und Elektronikmodul 3 erfolgt durch interne Verbindungsleitungen, die durch Aussparungen im Elektromotorgehäuse 21 und Elektronikmodulgehäuse 34 hindurchgeführt werden; die Aussparungen befinden sich bsp. im Bereich des ersten Lagerschilds 26, als Verbindungsleitungen sind bsp. Phasenenden vorgesehen.
Die mechanische Fixierung von Elektromotor 2 und Elektronikmodul 3 beim Zusammenfügen von Elektromotor 2 und Elektronikmodul 3 erfolgt durch Verschraubung des Elektronikmodulgehäuses 34 mit dem Elektromotorgehäuse 21 mittels Befestigungselementen 51 und Schrauben 52, wodurch eine kompakte integrierte elektrische Antriebseinheit 1 gebildet wird.

## Patentansprüche

1. Elektrische Antriebseinheit (1) aus Elektromotor (2) und Elektronikmodul (3), wobei
• der Elektromotor (2) ein doppelwandiges Elektromotorgehäuse (21) mit einer Außenwand (22) und einer Innenwand (23) aufweist, zwischen denen ein von einem Kühlmittel (44) durchströmter Kühlkreislauf (24) angeordnet ist,
• das Elektronikmodul (3) mindestens eine zu kühlende Funktionseinheit (31) und ein Elektronikmodulgehäuse (34) aufweist,
**dadurch gekennzeichnet,**
• **daß** die zu kühlende Funktionseinheit (31) des Elektronikmoduls (3) auf einem Kühlereinlegeteil (4) angeordnet ist,
• **daß** im Elektronikmodulgehäuse (34) eine zur Aufnahme des Kühlereinlegeteils (4) dienende Aussparung vorgesehen ist,
• **daß** in der Außenwand (22) des Elektromotorgehäuses (21) eine der Aussparung im Elektronikmodulgehäuse (34) entsprechende Aussparung vorgesehen ist, in die das Kühlereinlegeteil (4) derart eingebracht ist, daß es an der Innenwand (23) des Elektromotorgehäuses (21) anliegt.

2. Elektrische Antriebseinheit nach Anspruch 1, **dadurch gekennzeichnet, daß** die Unterseite (41) des Kühlereinlegeteils (4) zur Vergrößerung der vom Kühlmittel (44) umströmten Oberfläche mit Geometrieelementen (42) versehen ist.

3. Elektrische Antriebseinheit nach Anspruch 1 oder 2, **dadurch gekennzeichnet, daß** auf der Unterseite (41) des Kühlereinlegeteils (4) eine thermische Isolationsschicht (7) aufgebracht ist.

4. Elektrische Antriebseinheit nach Anspruch 3, **dadurch gekennzeichnet, daß** die thermische Isolationsschicht (7) als einseitig selbstklebende Kunststoffolie ausgebildet ist.

5. Elektrische Antriebseinheit nach einem der Ansprüche 1 bis 4, **dadurch gekennzeichnet, daß** das Elektronikmodulgehäuse (34) Aussparungen für Steckeranschlüsse (36, 37) zum Anschluß von Verbindungsleitungen für die Spannungsversorgung und von Steuerleitungen aufweist.

6. Elektrische Antriebseinheit nach einem der Ansprüche 1 bis 5, **dadurch gekennzeichnet, daß** die elektrische Verbindung von Elektromotor (2) und Elektronikmodul (3) über interne Verbindungsleitungen erfolgt.

7. Elektrische Antriebseinheit nach einem der Ansprüche 1 bis 6, **dadurch gekennzeichnet, daß** das Elektronikmodul (3) mehrere Funktionseinheiten (31; 32; 33) aufweist, die auf jeweils einem Trägerkörper (311; 321; 331) in verschiedenen Schaltungsebenen beabstandet voneinander angeordnet sind.

8. Elektrische Antriebseinheit nach Anspruch 7, **dadurch gekennzeichnet, daß** das Elektronikmodul (3) als beabstandet voneinander angeordnete Funktionseinheiten (31; 32; 33) aufweist:
• eine Leistungseinheit (31) mit einem Substrat als Trägerkörper (311), der auf dem Kühlereinlegeteil (4) angeordnet ist,
• eine auf einer Hochstrom-Leiterplatte als Trägerkörper (321) angeordneten Verbindungseinheit (32) zur Spannungsversorgung, Phasenverschienung und zur Kontaktierung von Bauelementen,
• eine Ansteuereinheit (33) mit einer Leiterplatte als Trägerkörper (331).

9. Elektrische Antriebseinheit nach Anspruch 8, **dadurch gekennzeichnet, daß** auf der Oberseite und/oder der Unterseite der Hochstrom-Leiterplatte (331) Verbindungselemente mit Ausgleichssicken vorgesehen sind.

## Claims

1. Electric drive unit (1) consisting of an electric motor (2) and of an electronic unit (3), wherein
• the electric motor (2) comprises a double-walled electric-motor housing (21) with an outside wall (22) and an inside wall (23) between which there is arranged a cooling circuit (24) through which a coolant (44) flows;
• the electronic unit (3) comprises at least one functional unit (31) to be cooled and an electronic-unit housing (34);
**characterized in**
• **that** the to-be-cooled functional unit (31) of the electronic unit (3) is arranged on a radiator insert (4);
• **that** a recess for receiving the radiator insert (4) is provided in the electronic-unit housing (34);
• **that** a recess that corresponds to the recess in the electronic-unit housing (34) is provided in the outside wall (22) of the electric-motor housing (21), wherein the radiator insert (4) is placed in the recess in the outside wall (22) in such a manner that it bears against the inside wall (23) of the electric-motor housing (21).

2. Electric drive unit according to claim 1, **characterized in that** the underside (41) of the radiator insert (4) is provided with geometrical elements (42) that serve to enlarge the surface around which the coolant (44) flows.

3. Electric drive unit according to claim 1 or 2, **characterized in that** the underside (41) of the radiator insert (4) is coated with a thermal insulating layer (7).

4. Electric drive unit according to claim 3, **characterized in that** the thermal insulating layer (7) is configured as a plastic sheet that is self-adhesive on one side.

5. Electric drive unit according to any one of claims 1 to 4, **characterized in that** the electronic-unit housing (34) comprises recesses for plug connections (36, 37) for the connection of connecting lines for power supply and of trip lines.

6. Electric drive unit according to any one of claims 1 to 5, **characterized in that** the electric motor (2) and the electronic unit (3) are electrically connected to each other via internal connecting lines.

7. Electric drive unit according to any one of claims 1 to 6, **characterized in that** the electronic unit (3) comprises several functional units (31; 32; 33) that are arranged spaced apart from each other on one carrier body (311; 321; 331) each on different circuit levels.

8. Electric drive unit according to claim 7, **characterized in that** the electronic unit (3) comprises the following functional units (31; 32; 33) that are arranged spaced apart from each other:
• a power unit (31) with a substrate as a carrier body (311), said carrier body (311) being arranged on the radiator insert (4);
• a connecting unit (32) for power supply, for forming a phase bar and for the contacting of components that is arranged on a carrier body (321) that is configured as a high-current printed circuit board;
• a drive unit (33) with a printed circuit board as a carrier body (331).

9. Electric drive unit according to claim 8, **characterized in that** connecting elements with compensating crimps are provided on the top side and/or the underside of the high-current printed circuit board (331).

## Revendications

1. Unité d'entraînement électrique (1) comprenant un moteur électrique (2) et un module électronique (3),
• le moteur électrique (2) présentant un boîtier de moteur électrique (21) à double paroi avec une paroi extérieure (22) et une paroi intérieure (23) entre lesquelles un circuit de refroidissement (24) traversé par un fluide de refroidissement (44) est disposé.
• le module électronique (3) présentant au moins une unité fonctionnelle devant être refroidie (31) et un boîtier de module électronique (34),
**caractérisée en ce que**
• l'unité fonctionnelle devant être refroidie (31) du module électronique (3) est disposée sur une pièce d'insertion de refroidissement (4).
• un évidement servant à la réception de la pièce d'insertion de refroidissement (4) est prévu dans le boîtier de module électronique (34).
• un évidement correspondant à l'évidement dans le boîtier de module électronique (34) est prévu dans la paroi extérieure (22) du boîtier de moteur électrique (21), dans lequel la pièce d'insertion de refroidissement (4) est placée de sorte qu'elle se trouve contre la paroi intérieure (23) du boîtier de moteur électrique (21).

2. Unité d'entraînement électrique selon la revendication 1, **caractérisée en ce que** la face inférieure (41) de la pièce d'insertion de refroidissement (4) est équipée avec des éléments de géométrie (42) pour l'agrandissement de la surface entourée par le fluide de refroidissement (44).

3. Unité d'entraînement électrique selon la revendication 1 ou 2, **caractérisée en ce qu'**une couche d'isolation thermique (7) est posée sur la face inférieure (41) de la pièce d'insertion de refroidissement (4).

4. Unité d'entraînement électrique selon la revendication 3, **caractérisée en ce que** la couche d'isolation thermique (7) est formée comme un film plastique autocollant sur un côté.

5. Unité d'entraînement électrique selon l'une des revendications 1 à 4, **caractérisée en ce que** le boîtier de module électronique (34) présente des évidements pour des prises (36, 37) pour le raccordement de lignes de connexion pour l'alimentation électrique et de lignes de commande.

6. Unité d'entraînement électrique selon l'une des revendications 1 à 5, **caractérisée en ce que** le raccordement électrique du moteur électrique (2) et du module électronique (3) a lieu par des lignes de connexion internes.

7. Unité d'entraînement électrique selon l'une des revendications 1 à 6, **caractérisée en ce que** le module électronique (3) présente plusieurs unités fonctionnelles (31 ; 32 ; 33) qui sont disposées respectivement sur un corps support (311 ; 321 ; 331) dans différents plans de circuit avec un écart entre elles.

8. Unité d'entraînement électrique selon la revendication 7, **caractérisée en ce que** le module électronique (3) présente des unités fonctionnelles (31 ; 32 ; 33) disposées avec un écart entre elles.
• une unité de puissance (31) avec un substrat comme corps support (311), qui est disposé sur la pièce d'insertion de refroidissement (4),
• une unité de connexion (32) disposée sur un circuit imprimé à haute intensité comme corps support (321) pour l'alimentation électrique, la barre de raccordement et la connexion de composants,
• une unité de commande (33) avec un circuit imprimé comme corps support (331).

9. Unité d'entraînement électrique selon la revendication 8, **caractérisée en ce que** des éléments de connexion avec des nervures de compensation sont prévus sur la face supérieure et/ou la face inférieure du circuit imprimé à haute intensité (331).
